# EUROPEAN PATENT APPLICATION

(11) **EP 1 249 830 A1**
(43) Date of publication of application: **16.10.2002**
(21) Application number: 02396049.5
(22) Date of filing: 11.04.2002
(51) Int. Cl.: G10L 19/08, G10L 19/14, H03M 7/42, H03M 7/30

(54) **A method for decompressing a compressed audio signal**

(30) Priority: 11.04.2001 FI 20010769
(71) Applicant: Nokia Corporation, 02150 Espoo (FI)
(72) Inventor: Ojanperä, Juha, 33710 Tampere (FI)
(74) Representative: Pursiainen, Timo Pekka

(57) **Abstract**

The invention relates to a method for decompressing a compressed audio signal. In the compression of an audio signal, samples are taken of the audio signal, which are compiled into sets of numerical values (w, x, y, z; x, y). From at least one codebook, an index corresponding to each set of numerical values (w, x, y, z; x, y) is searched for, and the symbol of the index is transmitted to the decompressing device (10). In the method, a decoding table corresponding to said at least one codebook is used, the decoded sets of numerical values (w, x, y, z; x, y) being determined on the basis of the decoded index. In the method, said at least one decoding table is formed by determining a codeword for each index in the decoding table, selecting a storage location for each numerical value of the set of numerical values (w, x, y, z; x, y) in said codeword, determining the values of the set of numerical values (w, x, y, z; x, y) corresponding to each index in the codebook, and placing the value of each numerical value (w, x, y, z; x, y) in the codeword corresponding to the index of the decoding table, in the location reserved for it in the codeword, wherein in decompressing of the audio signal, the codeword corresponding to the index of the symbol is searched for in the decoding table, and a value for each numerical value (w, x, y, z; x, y) is searched for in said location reserved for the numerical value (w, x, y, z; x, y) in the codeword. Thus, in the decompression of the compressed audio signal, the codeword corresponding to the index of the symbol is searched for in the decoding table, and a value for each numerical value (w, x, y, z; x, y) is retrieved from said location allocated for the numerical value (w, x, y, z; x, y) in the codeword.

## Description

The present invention relates to a method for decompressing a compressed audio signal according to the preamble of the appended claim 1, in which method samples are taken of the audio signal. The invention also relates to a system for transmitting an audio signal according to the appended claim 7, a decompressing device according to the appended claim 10, and an electronic device according to the preamble of the appended claim 11.

Various audio compression systems form compressed signals of an analog audio signal, such as a speech signal, which are stored and/or transmitted to a receiver or a decompressing device. In the receiver or decompressing device, an audio signal is formed on the basis of these compressed signals. In the compression, the quantity of information to be formed is affected *e.g.* by the fact how efficiently the compression can be performed at the transmission stage.

For the compression, digital samples are formed of an analog signal at intervals of *e.g.* 0.125 ms. These samples are preferably processed in sets of a fixed length, such as sets of samples formed during about 20 ms, which are subjected to compression operations. These sets of samples taken at intervals are also called frames.

In advanced audio coding (AAC) in the MPEG-4 system, samples representing an audio signal on the time level are converted to the frequency level, forming a set of signal spectrum components. These spectrum components are quantized, wherein each spectrum component is converted to a predetermined value which is either the next value greater than the value to be converted, or the preceding smaller value. After this, these quantized values are encoded, wherein the aim is to further reduce the quantity of information. For example, in the MPEG-4 system, Huffman coding is used in the compression of an audio signal, which is a so-called variable length coding (VLC) system, meaning that the length of the code words may vary. Another feature of the Huffman coding is that no code word is the beginning of another code word. In the coding, it is also possible to use several codebooks, of which a suitable one is selected for each quantized set of samples to be encoded. In the coding, a set of quantized samples is selected, which are encoded by using the same codebook. Thus, the decompressing device must be transmitted information about not only the code word but also the codebook represented by each set of code words.

The codebook is preferably formed as a table of two or four variables, which are signed or unsigned. Thus, the coding can be performed in sets of several spectrum components, wherein the code word is selected on the basis of the values of set of the spectrum components; that is, one code word is selected for each two or four components, to be transmitted to the communication channel or stored in a storage means, such as a CD-ROM, DVD or fixed disk.

Upon decompressing an audio signal, the operations reverse to the above operations are performed in the reverse order. Thus, on the basis of the codebook data of the received set of code words, a decoding table is selected, after which the indices corresponding to the code words of this set to be decoded, are determined. Each index refers to a certain location in the codebook, containing a value which can be used to determine the transmitted *e.g.* two or four quantized spectrum components. These decoded symbols are further subjected to reverse quantization, wherein the output signal of the decompressing device is a signal which substantially corresponds to the encoded audio signal. The compression, data transmission and decompressing may cause slight distortions in the signal, depending, for example, on how great quantizing steps are used, but these distortions do not normally have a great practical significance within the scope of capacity requirements of such a system.

A problem in such an audio compression system is the need of a high computing capacity at the decoding stage. This can be determined by the following pseudo code which represents the conversion of a received Huffman codebook index to corresponding either two or four spectrum component values.

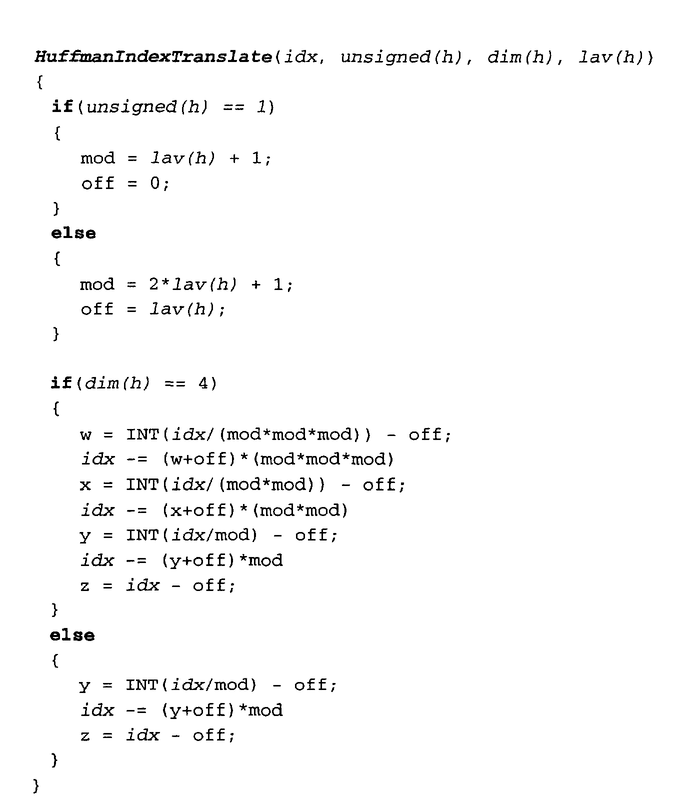

In the pseudo code, *idx* refers to the transmitted index, *unsigned(h)* indicates whether the values in the codebook are signed or unsigned, *dim(h)* is the dimension of the codebook, INT() represents a function whose input parameter is truncated without rounding to an integer, and *lav(h)* is the largest absolute value that the codebook can represent. Table 3.1 shows the values specified in the MPEG-4 standard, representing the different codebooks, for the above variables. If the values of the codebook are unsigned, the sign data is attached to the compressed signal, wherein the decompressing device can determine the sign of each value on the basis of this sign data.

**TABLE 3.1**

| Codebook # | unsigned(h) | dim(h) | lav(h) |
|---|---|---|---|
| 1 | 0 | 4 | 1 |
| 2 | 0 | 4 | 1 |
| 3 | 1 | 4 | 2 |
| 4 | 1 | 4 | 2 |
| 5 | 0 | 2 | 4 |
| 6 | 0 | 2 | 4 |
| 7 | 1 | 2 | 7 |
| 8 | 1 | 2 | 7 |
| 9 | 1 | 2 | 12 |
| 10 | 1 | 2 | 12 |
| 11 | 1 | 2 | 16 |

As indicated by the above pseudo code, the conversion of a given index to spectrum component values requires a large number of arithmetic operations. In particular, divisions require a high computing capacity (clock cycles or circuit board area). In the MPEG-4 system, the spectrum of an audio signal converted to the frequency level is divided into 1024 bits. Thus, in the worst case, 512 divisions are required per spectral frame. The provision of such a computing capacity is not an optimal solution and is unrealistic, particularly in portable devices.

It is an aim of the present invention to provide a method for making the decompressing of compressed audio signals more efficient. The method according to the present invention is characterized in what will be presented in the characterizing part of the appended claim 1. The system for transmitting an audio signal according to the present invention is characterized in what will be presented in the characterizing part of the appended claim 7. The decompressing device according to the present invention is characterized in what will be presented in the characterizing part of the appended claim 10. The electronic device according to the present invention is characterized in what will be presented in the characterizing part of the appended claim 11.

The present invention shows remarkable advantages compared to solutions of prior art. When applying the method of the invention, a significantly lower computing capacity is required to decompress a compressed signal than when using systems of prior art. Thus, the decompressing of a compressed signal can be performed fast, wherein real-time decompression of an audio signal can be implemented also in devices in which no efficient signal processors are available.

In the following, the invention will be described in more detail with reference to the appended drawings, in which
- Fig. 1: shows a system for transmitting an audio signal according to a preferred embodiment of the invention in a reduced block chart,
- Fig. 2: shows a decompressing device according to a preferred embodiment of the invention in a flow chart, and
- Figs. 3a to 3f: illustrate the principle of compiling decoding tables according to a preferred embodiment of the invention.

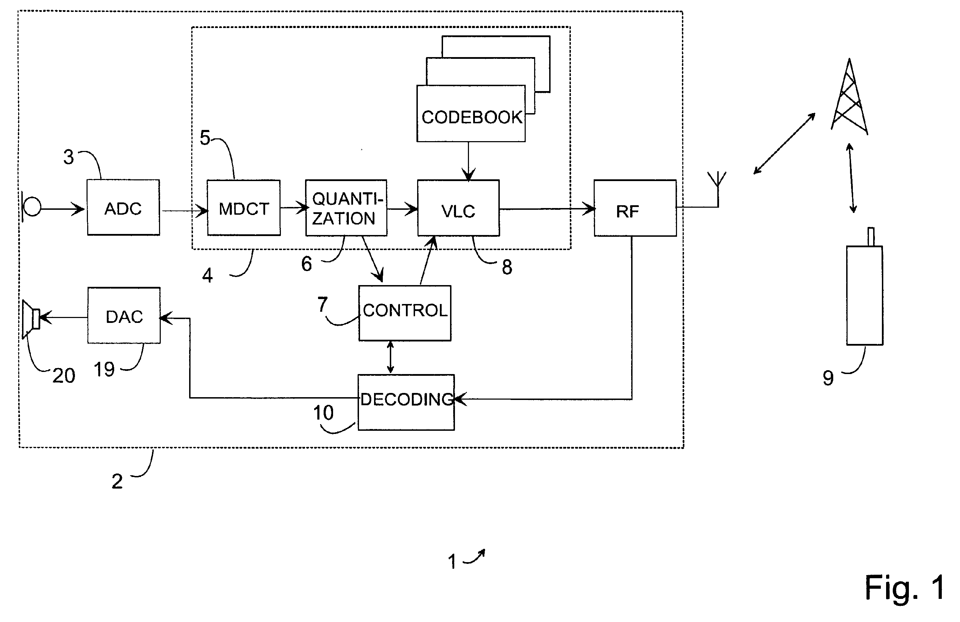

Figure 1 shows, in a reduced block chart, a system for transmitting an audio signal according to a preferred embodiment of the invention. In the system, the audio signal to be transmitted is, for example, a microphone signal of a wireless communication device 2. This microphone signal of the wireless communication device 2 is converted to digital form in an analog-to-digital converter 3, after which the signal is compressed in a compressing device 4. The compressing device 4 preferably comprises a time-to-frequency converter 5, such as a modified discrete cosine transform (MDCT) converter. The time-to-frequency converter 5 provides spectrum information representing the frequency response of the audio signal, comprising *e.g.* 1024 subfrequency ranges. Thus, of each sample frame, 1024 spectrum components are formed, which are quantized in a quantizing block 6. In the control block 7 of the compressing device, the quantized spectrum components are analyzed to determine which codebook is used in the compression of the spectrum components. On the basis of the analysis, information about the selected codebook is attached to the signal to be transmitted. Furthermore, on the basis of the selected codebook, the compression is performed in the coding block 8 preferably in the following way. The quantized spectrum components are divided into sets according to the dimension of the selected codebook, *i.e.* how many spectrum components are encoded into one code symbol in the selected codebook. The codebook symbol of each spectrum set is transmitted, for example, to a transmission buffer to be transmitted on a communication channel, or to be stored in a storage means before the actual compression. From the spectrum components quantized in the compression, a certain numerical value is calculated, which is called an index, and the bit pattern or code symbol corresponding to this index is searched in the codebook. After this corresponding value has been found, the code symbol is transferred to said transmission buffer.

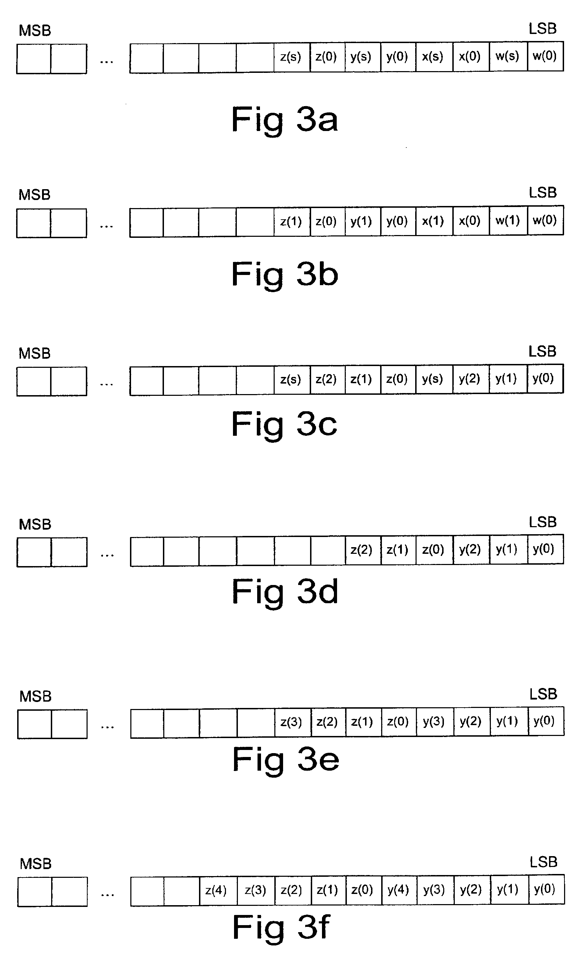

For decompressing, the electronic device 2, 9 comprises decoding tables which have been stored *e.g.* at the stage of manufacture of the electronic device and formed according to the following principles. For all possible quantized spectrum component values, numerical values w, x, y, z or y, z, depending on whether the set contains 2 or 4 values, are calculated for each codebook. The numerical values refer to the pseudo code presented above in this description. On the basis of these numerical values w, x, y, z or y, z, a codeword is formed to be stored in the decoding table, for example in the way shown in Figs. 3a to 3f. Figure 3a shows an example arrangement of numerical values in decoding tables #1 and #2. In a corresponding manner, Fig. 3b shows the example arrangement of numerical values in decoding tables #3 and #4, Fig. 3c shows the example arrangement of numerical values in decoding tables #5 and #6, Fig. 3d shows the example arrangement of numerical values in decoding tables #7 and #8, Fig. 3e shows the example arrangement of numerical values in decoding tables #9 and #10, and Fig. 3f further shows the example arrangement of numerical values in decoding tables #11. In the references of Figs. 3a to 3f, w(i) indicates the value of a bit i of the numerical value w so that i = 0 corresponds, in this preferred example, to the least significant bit. w(s) indicates the sign of the numerical value w in such a way that the value '1' indicates a negative numerical value. The codeword calculated in the above described manner is placed in the corresponding location indicated by the index in the decoding table. After all the codewords for the different indices and decoding tables have been calculated and placed in the decoding tables, these decoding tables can be used for decompressing of a compressed audio signal. This will be described in the following.

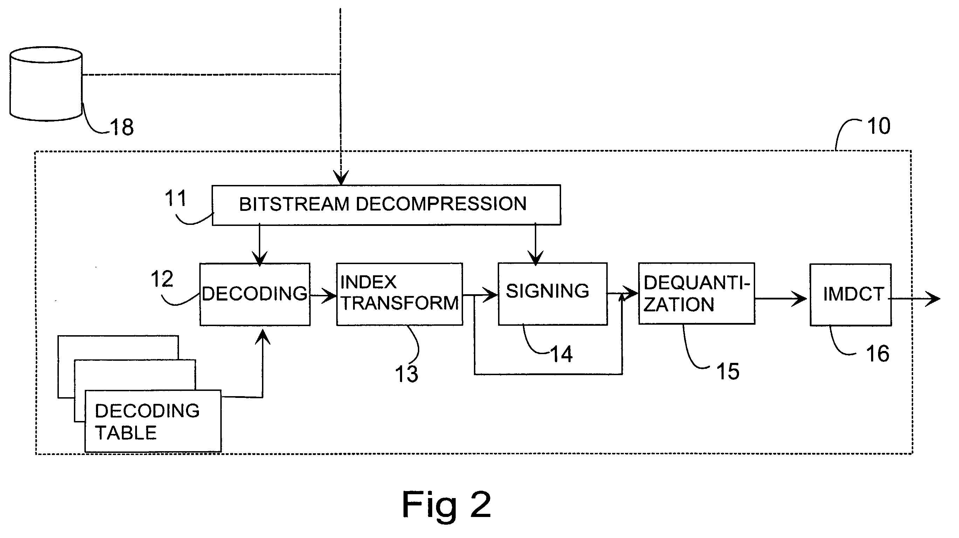

In the method according to a preferred embodiment of the invention, compression is preferably performed in the following way, with reference to the decompressing device 10 of Fig. 2. The audio signal to be decompressed is, for example, a microphone signal of a wireless communication device 2 or a compressed audio signal stored in a storage means 18. In the decompressing device 10, the signal (bit stream) to be decompressed is transferred to a bit demultiplexer 11 which interprets the bits of the bit stream to be decompressed, *e.g.* for the selection of the decoding table. The bit demultiplexer 11 transfers data about the decoding table to be used in the decompressing and the symbol to be decompressed, to a decoding block 12. Furthermore, the bit demultiplexer 11 transfers data about the signs to a signing block 14 in case the symbol to be decompressed contains unsigned numerical values, wherein the sign is transmitted in a bit stream to be decompressed separately. In the decoding block 12, the symbol to be decompressed is first subjected to Huffman decoding, to determine the symbol index in the codebook, the corresponding decoding values being stored in a corresponding decoding table.

An index conversion block 13 takes, on the basis of the determined index, the steps which numerical values the index corresponds to. This is preferably perfomed by setting a numerical indicator (not shown) or the like, to point at that memory location in the electronic device 2, 9, in which the codeword corresponding to the symbol according to the index of the decoding table is located. This storing of the table in a memory and its reading from the memory is technology known by anyone skilled in the art, wherein its description in more detail will not be necessary in this context.

From the memory location indicated by the numerical indicator is read the codeword contained therein, which is, thus, formed according to the principles presented above in this description. As the decoding result, this codeword provides the numerical values, preferably either two numerical values x, y or four numerical values w, x, y, z according to the codebook used at the coding stage. As it can be seen from Figs. 3a to 3f, these numerical values are easily obtained from the codeword by masking and bit shifting operations, requiring no multiplication or division operations which are necessary in decompressing methods of prior art. Consequently, decompression in this way requires a significantly lower computing capacity and/or a smaller circuit board area than in decompressing devices of prior art, wherein the decompression can be implemented even in relatively inexpensive portable electronic devices 2, 9. This will increase the applications of such audio signal compressing/decompressing systems to a significant degree.

Further, to clarify the decompression, the decoding table 3 will be used as an example, wherein the numerical values w, x, y, z can be formed from the codeword preferably in the following way. The codeword is first set as the value for the numerical value w. After this, bit-specific masking is performed in such a way that only the values of the two least significant bits (here LSB, LSB+1) are maintained; for the other bits, the value 0 is given in the masking. After this, the numerical value w only contains the bits w(0) and w(1), *i.e.* the decoding of the numerical value w is finished. The masking can be made *e.g.* by an AND operation, which is a very fast operation in most processors. For decoding of the numerical value x, the numerical value x is set as the codeword, after which masking is performed in such a way that the values of the bits LSB+2, LSB+3 are maintained. After this, the bits of the numerical value x are shifted two bits to the right (in the least significant direction), wherein the numerical value x is decoded. The decoding of the numerical values y and z can be performed by masking and bit transfer operations in a corresponding manner.

After the numerical values have been decoded, the numerical values are signed in the signing block 14, if the used coding/decoding tables only comprise unsigned numbers. In other cases, the sign has already been restored at the decoding stage, and the signing block 14 can be passed.

After this, the numerical values represent the quantized spectrum components, wherein they are subjected to reverse quantizing in a reverse quantizing block 15 and frequency-to-time conversion in a frequency-to-time conversion block 16 in a way known as such. After this, the output of the frequency-to-time conversion block 16 is a signal which substantially corresponds to the original audio signal, provided that no significant shifting and decompressing errors occurred at the stages of processing of the audio signal. This signal is further converted to an analog form in a digital-to-analog converter 19 (Fig. 1), after which the signal can be heard as a sound *e.g.* via a speaker 20.

It is obvious that the afore-described details of forming the codewords only represent an advantageous embodiment, wherein also other alternatives for arranging the numerical values can be applied in connection with the invention.

In the storage of the codewords for the decoding tables, it is possible to use either codewords of equal length in all the tables, or the length of the codewords may vary according to the maximum length of the codewords needed in each decoding table. In current memory solutions and processor environments, the length of the codewords is preferably a multiple of eight. For instance, in the examples of Figs. 3a to 3f, eight bits are sufficient in the decoding tables #1 to #10, but the decoding table #11 requires at least 10 bits, wherein preferably a 16-bit codeword is used in this decoding table #11. However, the extra bits are not taken into account in the decompression. It is obvious that in this case, 16-bit codewords can also be used for the decoding tables #1 to #10, wherein the same codeword address computing method can be used for decompression in all the decoding tables #1 to #11.

The above-presented method of compression and decompressing is only an example of how an audio signal can be transmitted in packed format. In the compression, it is also possible to apply so-called predicting compression, such as long term predictor LTP or the like, but also in this case, the above-presented principles can be applied in the decompressing of symbols to be transmitted to the decompressing device.

The different steps of the method according to the invention can be implemented, for example, in the application software of a control means 7. The control means 7 used can be, for example, a microprocessor, a digital signal processing unit, or the like.

The electronic device 2, 9 can be, for example, a wireless communication device, a portable computer, or a portable sound reproducing device. The audio signals to be decompressed are either transferred via communication means, or the audio signal can be stored in a storage means 18, such as a disk, a CD-ROM, a DVD, a memory card, such as FLASH, a fixed disk, or the like. The decoding tables can also be transmitted to the electronic device 2, 9 via a separate storage means, via a data transmission connection, or by another corresponding method.

Also in other respects, the present invention is not limited solely to the above-presented embodiments, but it can be modified within the scope of the appended claims.

## Claims

1. A method for decompressing a compressed audio signal, in which samples of an audio signal are taken upon compression of the audio signal, the samples are compiled into sets of numerical values (w, x, y, z; x, y), an index corresponding to each set of numerical values (w, x, y, z; x, y) is searched for in at least one codebook, and the index symbol is transmitted to a decompressing device (10), wherein in the method, a decoding table corresponding said at least one codebook is used, decoded sets of numerical values (w, x, y, z; x, y) being determined on the basis of the index decoded therefrom, **characterized in that** in the method, said at least one decoding table is formed by determining a codeword for each index in the decoding table, selecting a storage location for each numerical value of the set of numerical values (w, x, y, z; x, y) in said codeword, determining the values of the set of numerical values (w, x, y, z; x, y) corresponding to each index in the codebook, and placing the value of each numerical value (w, x, y, z; x, y) in the codeword corresponding to the index of the decoding table, in the location reserved for it in the codeword, wherein upon decompression of the audio signal, the codeword corresponding to the index of the symbol is searched for in the decoding table, and a value for each numerical value (w, x, y, z; x, y) is searched for in said location reserved for the numerical value (w, x, y, z; x, y) in the codeword.

2. A method according to claim 1, **characterized in that** the numerical values are binary digits, that the codeword is stored as a binary digit, and that one bit is reserved from the codeword for each bit of each numerical value.

3. A method according to claim 1 or 2, **characterized in that** in the compression, several codebooks are used, wherein the codebook to be used in the compression is selected on the basis of the set of numerical values (w, x, y, z; x, y), and that in the method, a decoding table is formed to correspond to each codebook.

4. A method according to claim 3, **characterized in that** in the method, data is transmitted about the codebook used in the compression of the set of numerical values, wherein in the decompression, the decoding table is selected on the basis of said codebook data.

5. A method according to any of the claims 1 to 4, **characterized in that** coding with variable length is used in the compression.

6. A method according to claim 5, **characterized in that** Huffman coding is used in the coding.

7. A system (1) for transmitting an audio signal, comprising a compressing device (4) for compressing an audio signal, and a decompressing device (10) for decompressing the audio signal, said means for compressing the audio signal comprising means for taking samples of the audio signal, means for compiling the samples into sets of numerical values (w, x, y, z; x, y), at least one index table, means for searching an index corresponding to each set of numerical values (w, x, y, z; x, y) from the codebook, and means for transmitting the symbol of the index to the decompressing device (10), wherein the decompressing device comprises a decoding table corresponding said at least one codebook, and means for determining a decoded set of numerical values (w, x, y, z; x, y) on the basis of the decoded index decoded, **characterized in that** said decoding table is formed by determining a codeword for each index in the decoding table, selecting a storage location for each numerical value of the set of numerical values (w, x, y, z; x, y) in said codeword, determining the values of the set of numerical values (w, x, y, z; x, y) corresponding to each index in the codebook, and placing the value of each numerical value (w, x, y, z; x, y) in the codeword corresponding to the index of the decoding table, in the location reserved for it in the codeword, wherein the means for decompressing the audio signal comprise means for searching for the codeword corresponding to the index of the symbol in the decoding table, and means for searching for a value for each numerical value (w, x, y, z; x, y) in said location reserved for the numerical value (w, x, y, z; x, y) in the codeword.

8. A system according to claim 7, **characterized in that** it comprises two or more codebooks and the corresponding decoding tables, and means for selecting the codebook to be used in the compression of the set of numerical values (w, x, y, z; x, y) on the basis of the set of numerical values.

9. A system according to claim 7 or 8, **characterized in that** it comprises means for transmitting data about the codebook used in the compression of the set of numerical values to the compressing device (10), wherein the compressing device (10) comprises means for selecting the decoding table for the decompression on the basis of said codebook data.

10. A decompressing device for decompressing a compressed audio signal, wherein samples of the audio signal have been taken during compression of the audio signal, the samples have been compiled into sets of numerical values (w, x, y, z; x, y), an index corresponding to each set of numerical values (w, x, y, z; x, y) has been searched for in at least one codebook, and the symbol of the index has been transmitted to a decompressing device (10), wherein the decompressing device comprises a decoding table corresponding to said at least one codebook, and means for determining a decoded set of numerical values (w, x, y, z; x, y) on the basis of the decoded index, **characterized in that** said decoding table is formed by determining a codeword for each index in the decoding table, selecting a storage location for each numerical value of the set of numerical values (w, x, y, z; x, y) in said codeword, determining the values of the set of numerical values (w, x, y, z; x, y) corresponding to each index in the codebook, and placing the value of each numerical value (w, x, y, z; x, y) in the codeword corresponding to the index of the decoding table, in the location reserved for it in the codeword, wherein the means for decompressing the audio signal comprise means for searching for the codeword corresponding to the index of the symbol in the decoding table, and means for searching for a value for each numerical value (w, x, y, z; x, y) in said location reserved for the numerical value (w, x, y, z; x, y) in the codeword.

11. An electronic device (2, 9), which comprises a decompressing device (10) for decompressing an audio signal, wherein samples have been taken of the audio signal during compression of the audio signal, the samples have been compiled into sets of numerical values (w, x, y, z; x, y), an index corresponding to each set of numerical values (w, x, y, z; x, y) has been searched for in at least one codebook, and the symbol of the index has been transmitted to the decompressing device (10), which decompressing device (10) comprises a decoding table corresponding said at least one codebook, and means for determining a decoded set of numerical values (w, x, y, z; x, y) on the basis of the decoded index, **characterized in that** said decoding table is formed by determining a codeword for each index in the decoding table, selecting a storage location for each numerical value of the set of numerical values (w, x, y, z; x, y) in said codeword, determining the values of the set of numerical values (w, x, y, z; x, y) corresponding to each index in the codebook, and placing the value of each numerical value (w, x, y, z; x, y) in the codeword corresponding to the index of the decoding table, in the location reserved for it in the codeword, wherein decompressing device (10) comprises means for searching for the codeword corresponding to the index of the symbol in the decoding table, and means for searching for a value for each numerical value (w, x, y, z; x, y) in said location reserved for the numerical value (w, x, y, z; x, y) in the codeword.
